Europäisches Patentamt

European Patent Office

Office européen des brevets

(11) Publication number: **0 299 475 B1**

# EUROPEAN PATENT SPECIFICATION

(45) Date of publication of patent specification: **14.09.94**   (51) Int. Cl.5: **G02B 19/00**

(21) Application number: **88111320.3**

(22) Date of filing: **14.07.88**

(54) Optical system for effecting increased irradiance in peripheral area of object.

(30) Priority: **17.07.87 JP 179630/87**
**31.07.87 JP 193327/87**
**31.07.87 JP 193328/87**
**31.07.87 JP 193329/87**
**07.08.87 JP 198775/87**

(43) Date of publication of application:
**18.01.89 Bulletin 89/03**

(45) Publication of the grant of the patent:
**14.09.94 Bulletin 94/37**

(84) Designated Contracting States:
**DE FR GB IT**

(56) References cited:
**EP-A- 0 231 029**
**DE-A- 2 803 277**
**DE-A- 3 505 771**

**PATENT ABSTRACTS OF JAPAN, vol. 7, no.**
**125 (P-200)[1270] 31st May 1983;& JP-A-58 43**
**416**

(73) Proprietor: **Dainippon Screen Mfg. Co., Ltd.**
**1-1, Tenjinkitamachi**
**Teranouchi-Agaru 4-chome**
**Horikawa-Dori**
**Kamikyo-ku Kyoto 602 (JP)**

(72) Inventor: **Nagata, Shinichi Danippon Screen**
**Mfg. Co., Ltd.**
**1-1 Tenjikitamachi**
**Teranouchi-agaru**
**4-chome**
**Horikawa.-dori Kamikyo-ku Kyoto 602 (JP)**
Inventor: **Uemura, Haruo Danippon Screen**
**Mfg. Co., Ltd.**
**1-1 Tenjikitamachi**
**Teranouchi-agaru**
**4-chome**
**Horikawa.-dori Kamikyo-ku Kyoto 602 (JP)**
Inventor: **Endo, Kenji Danippon Screen Mfg.**
**Co., Ltd.**
**1-1 Tenjikitamachi**
**Teranouchi-agaru**
**4-chome**
**Horikawa.-dori Kamikyo-ku Kyoto 602 (JP)**

(74) Representative: **Goddar, Heinz J., Dr. et al**
**FORRESTER & BOEHMERT**
**Franz-Joseph-Strasse 38**
**D-80801 München (DE)**

## Description

The present invention relates generally to a novel optical system, and particularly to an optical system which provides light of increased irradiance in the peripheral area of an object to be irradiated, so that it is particularly useful for an illumination system or a projection system applicable to exposure of printed circuit boards, integrated circuits or the like, for exposure system applicable to contact exposure apparatus for plate making, step-and-repeat machines or the like, and for an illumination system applicable to copy machines or the like.

As state of the art, the EP-A-0 231 029 has to be mentioned, a European Patent Application by the same applicant as this document, which is also solving the problem of providing an optical system which provides an illumination on an object without any illuminance reduction in the peripheral area of the object. The optical system according to this document, however, is not able to provide an illumination height of the peripheral area of the object which is greater than that of the central area of the object.

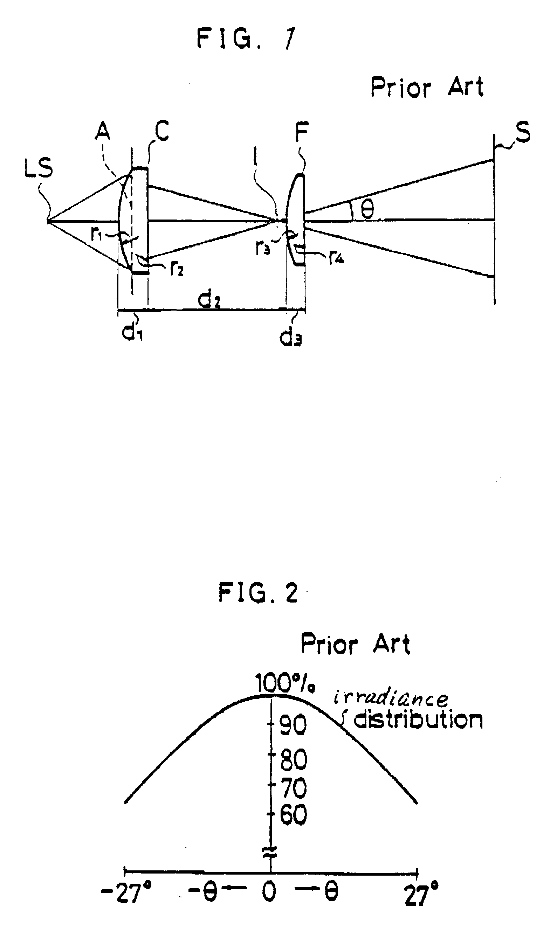

It is well known that a conventional relay condenser optical system as shown in Figure 1 has been used in an illumination system which is intended to provide an illumination light for an entire object area uniformly and effectively. The conventional condenser optical system, referring to Figure 1, comprises a condenser lens C and a field lens F. The condenser optical system is designed so that the real image of a light source LS, which is placed in front of the condenser lens C, is formed adjacent to the field lens F, and that real image of an entrance pupil A of the condenser lens C is formed on an object S which is placed behind the field lens F.

The conventional condenser optical system, however, raises a serious problem, i.e. the irradiance in the peripheral area of the object is reduced, as shown in Figure 2, in accordance with the cosine fourth law. For instance, referring to Figure 1, the irradiance at the point on the object, where the exit angle $\theta$ forms 27 degrees relative to the optical system, is less than that at the point on the optical axis, i.e. the point where the exit angle $\theta$ forms zero degree.

There are several reasons, other than the above-mentioned cosine fourth law, for the occurrence of irradiance reduction in the peripheral area of the object, which will be discussed in detail later. Actually, the irradiance in the peripheral area of the object is reduced less than a value derived from the cosine fourth law. According to the simulation calculation made by applying lens data listed in Table 1 to the optical system shown in Figure 1, it is found that the irradiance at the point where the exit angle $\theta$ forms 27 degrees, is reduced by 50 percent in comparison with the irradiance at the center thereof.

TABLE 1

|   | r | d | n |
|---|---|---|---|
| 1 | 0.77 | 0.37 | 1.5 |
| 2 | ∞ | 0.46 | |
| 3 | 0.77 | 0.37 | 1.5 |
| 4 | ∞ | | |

f = 1, distance from the light source = 50, distance from the object = 100

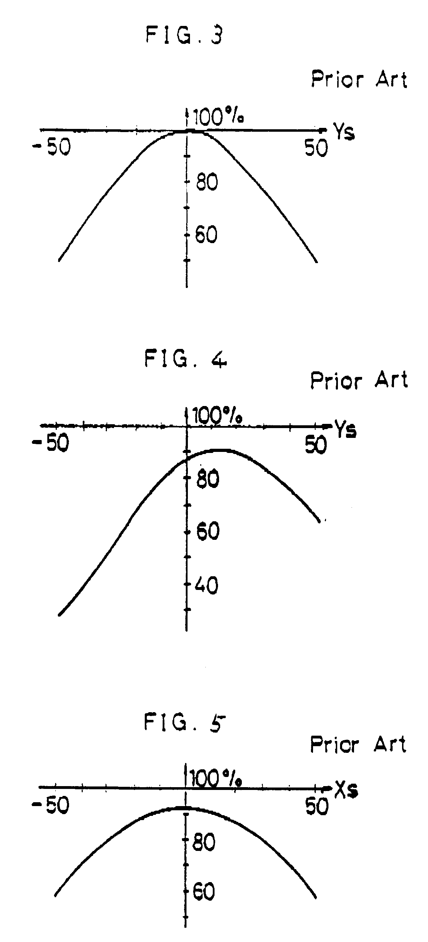

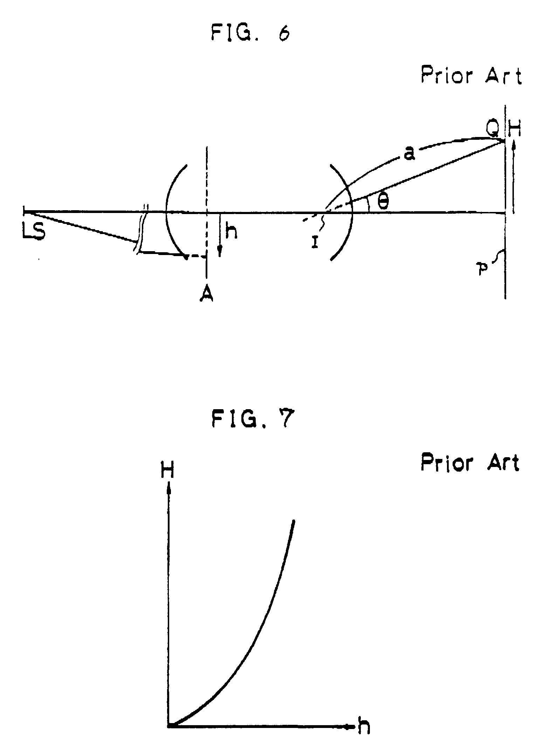

Figure 3 shows an irradiance distribution on the object P, which is obtained by using the optical system shown in Figure 1, in the case where a point source is positioned on the optical axis at the distance of 50 away from the optical system. Figure 4 shows an irradiance distribution of the meridional ray on the object P, and Figure 5 shows an irradiance distribution of the sagittal ray on the object P, in each of which the point source is positioned away by 14 from the optical axis and at a distance of 50 from the optical system. The respective vertical axis of Figure 3 through 5 depicts a relative irradiance, in which the irradiance of the center of the object P is regarded as 100 percent when the point source is positioned on the optical axis. On the other hand, the respective horizontal axis of Figures 3 through 5 depicts a position on the object P. In Figures 3 through 5, the position denoted by 50 corresponds to the position on which the exit light from the optical system is impinged.

As mentioned above, the irradiance in the peripheral area of the object P is actually reduced less than a value derived from cosine fourth law. One of the reasons therefor is an abberation, because the cosine fourth law is on the premise that an optical system has no abberation, whereas an actual optical system inevitably has the aberration.

It has then conventionally been practiced that an optical system is designed so that the aberration be eliminated as far as possible, in other words it has commonly been practiced that an optical system is designed so as to satisfy the sine condition. Thus, even in an illumination system, the optical system for use in illumination has conventionally been designed so as to satisfy the sine condition, because it has been believed as a matter of course by a person skilled in the art.

It has been found by the inventors, however, that designing an optical system so as to satisfy the sine condition causes an irradiance reduction in the peripheral area of the object to be illuminated.

Now, discussion is given with regard to the reasons why the irradiance reduction in the peripheral area of the object will be caused.

Referring to Figure 6, which is a schematic view of an optical system, light emitted from the light source LS enters into the optical system at the entrance height h, in this case the light source LS can be regarded as being placed at an infinite distance from the optical system, because it is positioned at a far distance from the optical system in comparison with the focal length thereof. The real image of the light source LS is formed at a point I, and the light goes through an exit pupil at an exit angle $\theta$. Satisfying the sine condition means that the sine of the exit angle $\theta$ is proportioned to the entrance height h, accordingly the relation can be expressed by the following formula (1):

$$h = k_1 \cdot \sin \theta \qquad (1)$$

where $k_1$ is a proportional constant.

The light which entered into the optical system at the entrance height h exits therefrom to impinge upon the point Q of the object P. Then, $\sin \theta$ can be expressed by the following formula (2):

$$\sin \theta = \frac{H}{a} \qquad (2)$$

where H is the distance between the point Q and the center of the object P (hereinafter referred to as illumination height), and a is the distance between the point I and the point Q.

It can then be transformed from the formulae (1) and (2), as follows:

$$H = \left( \frac{1}{k_1} \right) \cdot a \cdot h \qquad (3)$$

As can be understood from Figure 6, when the incident height h is increased, the exit angle $\theta$ will become large, hence the illumination height H will be increased in accordance therewith, and similarly the distance a between the point I and the point Q will also be increased. In the case where the entrance height h is increased at a constant rate, the illumination height H will be rapidly increased more than the increase of the entrance height h, since the illumination height H is proportioned to the product of the distance a and the incident height h, as can be seen from the formula (3). The relationship between the incident light radius $A_0$ around the optical axis in the entrance pupil A and the radius $P_0$ of the illumination area of the object P, similarly to the relationship between the incident height h and the illumination height H, is that the radius $P_0$ increases at a greater rate than the rate at which the radius A increases, from which it will be apparent that the irradiance on the object P will be reduced as it goes away from the optical axis, in comparison with that on the entrance pupil A.

Indeed in an image-formation optical system design it will be necessary to design the optical system so as to satisfy the sine condition because it is important to minimize the aberration, but in an illumination optical system design there is no need to do so. Furthermore, designing to satisfy the sine condition causes the irradiance reduction in the peripheral area of the object to be illuminated, as mentioned above.

In a conventional illumination system, it has been practiced in order to correct the irradiance reduction in the peripheral area of the object, that a gradient filter is placed in the optical path thereof, or that the light source is placed at a sufficient distance from the object. These conventional correction methods are, however, disadvantageous in view of the fact that light quantity is considerably reduced in the entire area of the object in the former method, and that the illumination system inevitably becomes large in size in the latter.

Furthermore, it may often be required that irradiance in the peripheral area of an object is increased in comparison with that at the center thereof. For instance, in the case where an illumination apparatus when employing a projection lens is placed optically behind an original to be reproduced, an image projected on a photosensitive material will be effected by the cosine fourth law even if uniform irradiance is given throughout the original.

## SUMMARY OF THE INVENTION

It is a principal object of the present invention to provide a novel optical system particularly useful for an illumination system.

It is another object to provide an optical system which provides an illumination on an object with increased irradiance in the peripheral area of the object.

It is a further object to proide an optical system adaptable for illuminating a considerably large-scaled object, e.g. 900 mm by 900 mm.

The aforementioned objects are accomplished by subject matter of claim 1. An optical system which includes a light source, an entrance pupil for receiving light from the light source, an exit pupil for passing the light received to the object, and an optical axis which extends to the light source and the object, respectively, through the optical system, wherein the relationship among an incident height h to the entrance pupil, an illumination height H on the object and a changing rate $(dh/dH)$ of the incident height and the illumination height id defined by a function, $f(H) = (h/H)(dh/dH)$, the optical system being designed so as to satisfy the following formula in the peripheral area of the object: $f(0) \leq f(H)$, $f(0)$ being represented by the formula: $f(0) = [fa'/\{(a'-f)b'\}]^2$, where $a'$ is a distance between the light source and the primary principal point of the optical system, and $b'$ is a distance between the real image of the light source and the object is preferable.

Such an optical system may comprise three optical units, the first optical unit including a positive lens and having the rear surface which is formed into convex, the second optical unit including a positive lens and having the front surface which is formed into convex, third optical unit including either a positive or negative lens and having the rear surface which is formed into convex, the optical system satisfying the following formulae:

$$-0.3f < f_F < 0.3f \qquad (13)$$

$$0.4 < (1-n_5)f/r_6 \qquad (14)$$

$$-0.6f < f_B < 0.1f \qquad (15)$$

$$0.04 < (1-n_1)f/r_2 < 0.8 \qquad (16)$$

$$(1-n_3)/r_4 + (n_5-1)/r_5 < 0 \qquad (17)$$

where f is the synthesized focal point of the optical system; $f_F$ is a distance between the front surface of the first optical unit and the primary focal point of the optical system; $f_B$ is a distance between the rear surface of the third optical unit and the secondary focal point of the optical system; $n_1$, $n_3$ and $n_5$ are respectively the refractive index of the first, second and third optical units; $r_2$ and $r_4$ are respectively the radius of curvature of the rear surfaces of the first and second optical units; and $r_5$ and $r_6$ are respectively the radius of curvature of the front and rear surfaces of the third optical unit.

Such an optical system may further comprise four optical units, the first optical unit including a positive lens and having a rear surface which is formed into convex, the second optical unit including either a positive or negative lens and having a rear surface which is formed into convex, the third optical unit including a positive lens and having a front surface formed into convex, the fourth optical unit including a positive lens and having a rear surface formed into convex, the synthesized focal length of both the first and second optical units being positive, the optical system satisfying the following formulae:

$$0.8 \leq \{(n_5-1)/r_5 + (1-n_7)/r_8\}f \qquad (58)$$

$$0.75f \leq f_{3.4} \leq 1.52f \qquad (59)$$

where f is a synthesized focal length of the optical system; $f_{3.4}$ is a synthesized focal length of both the third and fourth optical units; $n_5$ and $n_7$ are respectively the refractive index of the third and fourth optical units; and $r_5$ and $r_8$ are respectively the radius of curvature of the third and fourth optical units.

Or, according to a further embodiment, the optical system may comprise two optical units, the first optical unit including a positive lens and having a rear surface which is formed into convex, the second optical unit including a positive lens and having a front and rear surface which are formed into convex, the optical system satisfying the following formulae:

$$-0.3 \leq (d_3/r_4) \leq -0.3 \qquad (76)$$

$$1.0f \leq f_2 \leq 1.55f \qquad (77)$$

where f is a synthesized focal length of the optical system; $f_2$ is the focal length of the second optical unit; $d_3$ is the thickness of the second optical unit; and $r_4$ is the radius of curvature of the rear surface of the second optical unit.

According to the present invention, the optical system comprises two optical units, the first optical unit including a positive lens and having a rear surface which is formed into convex, the second optical unit including a positive lens and having a front surface which is formed into concave and a rear surface which is formed into convex, the optical system satisfying the following formulae:

$$-0.68 \leq \{(1-n_1)/r_2 + (n_3-1)/r_3\}f \leq 0.90 \qquad (90)$$

$$0.67 \leq \{(1-n_3)/r_4\}f \qquad (91)$$

where f is the synthesized focal length of the optical system; $r_2$, $r_3$ and $r_4$ are a radius of curvature of the rear surface of the first optical unit, of the front and rear surfaces of the second optical unit, respectively; and $n_1$ and $n_3$ are refractive indexes of the first and second optical units.

The optical system is preferably formed into so-called a fly's eye configuration.

Having the aforementioned features, the present invention has the following useful advantages:

The optical system according to the present invention effectively resolves the irradiance reduction caused by the cosine fourth law and/or vignetting in the peripheral area of an object to be illuminated.

The optical system rather increases the irradiance in the peripheral area of an object to be illuminated, which fact reveals that the optical system is particularly useful in the case where the image of the object is in turn projected onto e.g. a photosensitive material. The resultant irradiance distribution on the photosensitive material can be ensured to be uniform throughout the entire surface thereof.

The optical system according to the present invention is accordingly adaptable for illuminating a considerably large-scaled object.

Other novel features and advantages of the invention will become apparent in the course of the following detailed description taken together with the accompanying drawings, which are directed only to the understanding of the present invention and not to the restriction of the scope of the invention.

BRIEF DESCRIPTION OF THE DRAWINGS

Figure 1 is an elevational view of a conventional optical system;
Figure 2 is a graphic representation which shows irradiance distribution of the conventional optical system;
Figures 3 through 5 are respectively graphic representations of the irradiance distribution on the object, when using the conventional optical system;
Figure 6 is a schematic elevational view of the conventional optical system;
Figure 7 is a graphic representation which shows the relationship between the entrance height and the illumination height;
Figure 8 is a schematic view of the illumination apparatus according to the present invention;
Figure 9 is a schematic view of the illumination apparatus according to present invention;
Figure 10 is a side view of the lenses forming the optical system;
Figures 11 and 12 are explanatory side views showing the light rays advancing through the optical system;
Figure 13 is a graphic representation showing an irradiance distribution on an object;
Figure 14 is a side view of the lenses forming the optical system;
Figure 15 is a graphic representation showing an irradiance distribution on an object;
Figure 16 is a side view of the lenses forming the optical system;
Figure 17 is a graphic representation showing an irradiance distribution on an object;

Figure 18 is a side view of the lenses forming the optical system;
Figure 19 is a graphic representation showing an irradiance distribution on an object;
Figure 20 is a side view of the lenses forming the optical system;
Figure 21 is a graphic representation showing an irradiance distribution on an object;
Figure 22 is a graphic representation showing an irradiance distribution on a photosensitive material;
Figure 23 is a schematic side view of an illumination apparatus according to the present invention;
Figure 24 is a graphic representation showing a vignetting factor of a projection lens; and
Figure 25 is a graphic representation showing an irradiance distribution on a photosensitive material.

## DETAILED DESCRIPTION OF THE PREFERRED EMBODIMENTS

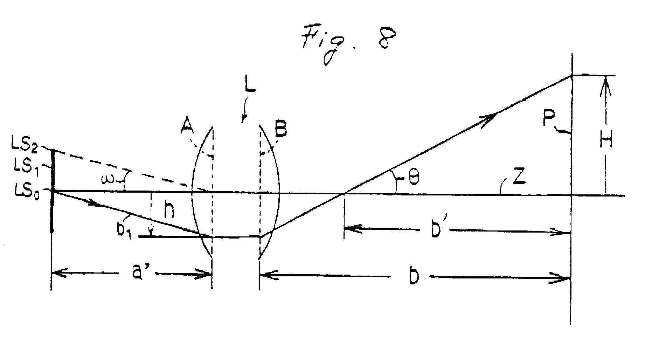

Referring to Figure 8, a light source LS locates on the optical axis Z, and, when the light ray $b_1$ emitted from the center $LS_0$ of the light source LS entering into the entrance pupil A of a lens L at the entrance height h, the light ray $b_1$ advances through the lens L and emerges from the exit pupil B, to reach the object P at the height H.

Whereas, the light ray entering into the entrance pupil at the height $h + \Delta h$ reaches the object at the height $H + \Delta H$. In this case, assuming that the light intensity is not lost during the light transmits through the lens, the radient flux transmitted through the area $\Delta S_1$ between the circle of radius h and that of radius $h + \Delta h$ reaches the area $\Delta S_2$ between the circle of radius H and that of radius $H + \Delta H$. Those areas $\Delta S_1$ and $\Delta S_2$ are represented as follows:

$$\Delta S_1 = \pi\{(h + \Delta h)^2 - h^2\} \qquad (4)$$

$$\Delta S_2 = \pi\{(H + \Delta H)^2 - H^2\} \qquad (5)$$

Assuming that the irradiance at the incident height h at the entrance pupil A is defined as e, the irradiance E at the illumination height H on the object P can be expressed as follows:

$$E = e(\Delta S_1 / \Delta S_2)$$
$$= e(2h\Delta h + \Delta h^2)/(2H\Delta H + \Delta H^2)$$
$$= e(\Delta h/\Delta H)\left\{(2h + \Delta h)/(2H + \Delta H)\right\} \qquad (6)$$

Then, assuming that $\Delta H$ is brought infinitely close to zero, the following formulae are obtained:

$$\lim_{\Delta H \to 0} (\Delta h/\Delta H) = (dh/dH) \qquad (7)$$

$$\lim_{\Delta H \to 0} (2h + \Delta h)/(2H + \Delta H) = (h/H) \qquad (8)$$

The formula (6) then can be expressed as follows:

$$E = e \cdot f(H) \qquad (9)$$

where $f(H) = (dh/dH)(h/H)$.

In order to increase the irradiance in the peripheral area of the object, the optical system according to the present invention is designed so as to satisfy the following formula:

$$f(0) \leq f(H) \qquad (9')$$

In the case where the irradiance e in the entrance pupil A can be regarded as constant independent of the incident height h, in other words, in the case where the irradiance distribution in the entrance pupil A is uniform, the aforementioned function f(H) represents the relative irradiance on the object P in connection with the irradiance e.

The relative irradiance at the illumination height H = 0 on the object P is represented by the function f(0), whereas the relative irradiance at the illumination height H = 0 thereon is represented by the function f(H).

By the way, the paraxial region the illumination height H can be expressed as follows:

$$H = -\{(a'-f)/fa'\}b'h \qquad (10)$$

then, the function f(0) can be expressed as follows:

$$f(0) = [fa'/\{(a'-f)b'\}]^2 \qquad (11)$$

where a' is the distance between the light source and the primary principal point, f is the focal length, and b' is the distance between the real image of the light source and the object.

FIRST EMBODIMENT

Referring to Figure 9, which shows a schematic view of the illumination apparatus according to the present invention, the illumination apparatus comprises a light source 1, an ellipsoidal mirror 2 provided with respect to the light source, an optical system 3 e.g. formed into a fly's eye configulation, a diffusing plate 4, an original 5 to be reproduced placed immediately behind the diffusing plate, a projection lens 6 and a photosensitive material 7, in order. The light source 1 is of a mercury lamp, with respect to which the ellipsoidal mirror 2 is provided. The ellipsoidal mirror is designed that the the exit terminal thereof is 170 mm in radius. The optical system 3 is placed by 500 mm away from the exit terminal of the light source. Light reflected by the marginal end of the mirror 2 forms 18.8 degrees relative to the optical axis, to be received by the optical system 3. Light emerged from the optical system 3 impinges upon the diffusing plate 4, by which the light is well diffused suitable for uniform illumination of the original. The diffusing plate 4 is placed by 1000 mm away from the exit terminal of the optical system 3. The original 5, e.g. a transparency, is placed immediately behind the diffusing plate. The projection lens 6 is designed so that the focal length thereof is 600 mm, which projection lens is placed by 1200 mm away from the original 5. The photosensitive material 7 is placed by 1200 mm away from the exit terminal of the projection lens. In this case, the entire area of an original having 900 mm in diagonal is illuminated, and the image illuminated is projected on the photosensitive material in 1:1 in magnification.

As mentioned above, the optical system 3 is formed into a fly's eye configulation, wherein a plurality of element optical systems are aligned in two-dimensionally. In the embodiments shown hereinafter, only one of such element optical systems is illustrated.

Hereinafter described are examples of the optical system 3 to be employed in the illumination apparatus shown in Figure 9. In the following examples, the respective optical elements shown in Figure 8 are designed that the focal length of the lens L (i.e. optical system 3 in Figure 9) is 1.0; the distance between the light source LS and the optical system L (i.e. optical system 3 in Figure 9) is 50; and size of the light source LS is $2a' \cdot \tan\omega$.

In the case where any surface designed into aspherical, such aspherical surface will be defined with both the Z-coordinate corresponding to the optical axis and the Y-coordinate corresponding to the height from the optical axis, and the value of the Z-coordinate will be represented by the following formula:

$$Z = CY^2/[1 + \{1-(K+1)C^2Y^2\}^{\frac{1}{2}}] + A_1Y^4 + A_2Y^6 + A_3Y^6 + A_4Y^{10} \qquad (12)$$

where C = 1/r (r is a radius of curvature); K is a conic constant; and $A_1$, $A_2$, $A_3$ and $A_4$ are aspheric constants.

According to the present invention, the optical system 3 employed in the illumination apparatus shown in Figure 9 includes two optical units including two lenses, the first optical unit comprising a single positive lens and having a rear surface which is formed into convex, the second optical unit comprising a single positive lens and having both a front surface which is formed into concave and a rear surface which is formed into convex, the optical system being designed to satisfy the following formulae:

$$-0.68 \leq \{(1-n_1)/r_2 + (n_3-1)/r_3\}f \leq 0.90 \qquad (90)$$

$$0.67 \leq \{(1-n_3)/r_4\}f \qquad (91)$$

where f is the synthesized focal length of the optical system as a whole; $r_2$, $r_3$ and $r_4$ are a radius of curvature of the rear surface of the first optical unit, of the front and rear surfaces of the second optical unit, respectively; and $n_1$ and $n_3$ are refractive indexes of the first and second optical units.

In this embodiment, both the distance a between the light source and the front surface of the optical system and the distance b' between the rear surface of the optical system and the object are sufficiently large in comparison with the synthesized focal length f. The intermediate image of the light source is formed in the vicinity of the second lens, whereas the image of the entrance pupil A is formed on the object by the second lens.

This embodiment performs substantially the same functions as the fourth embodiment. For example, as shown in Figure 11, the incident rays entering into the optical system are subject to the refracting power of the rear surface of the first lens $L_1$, and then at the larger incident height the ray enters, the more strongly the refracting power of the rear surface of the first lens acts on the same due to the spherical aberration. The intersection $I_1$ of both a marginal ray $Q_1$ and the optical axis Z accordingly locates before the intersection $I_2$ of both a paraxial ray $Q_2$ and the optical axis.

The rear surface $r_4$ of the second lens $L_2$ locates behind the intersections $I_1$ and $I_2$ and has a strong refracting power. The refracting power of the surface $r_4$ will not act on the marginal ray $Q_1$, and the diverging function will rather act on the paraxial ray $Q_2$. The optical system of this embodiment controls the exit angle of the rays entering at relatively large incident height, so that the irradiance reduction in the peripheral area of the object is effectively resolved.

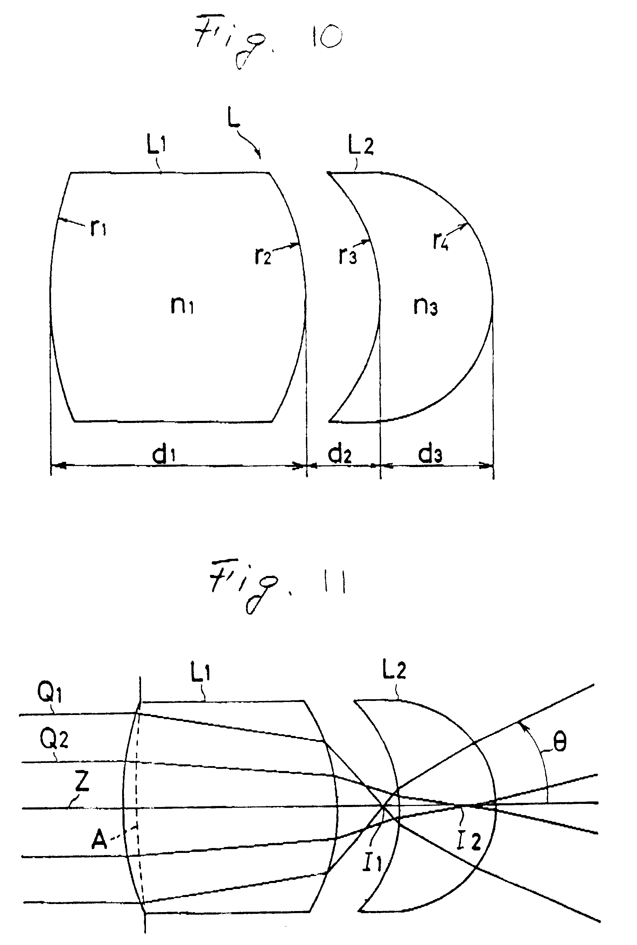

The rear surface of the first lens $L_1$ effects the positive coma, which implies that the rear surface $r_2$ of the first lens $L_1$ is defined within the range where the incident height to the rear surface $r_4$ of the second lens $L_2$ of a marginal ray $Q_3$ will not become excessively large, as can be seen in Figure 12. This is because, when the incident height to the rear surface $r_4$ of the second lens is excessively large, the exit angle $\theta$ therefrom will, to the contrary, become excessively small due to the refracting power of the surface $r_4$, and the effective illumination area will accordingly become small.

The optical system of this embodiment is designed to satisfy the formulae (90) and (91):

$$-0.68 \leq \{(1-n_1)/r_2 + (n_3-1)/r_3\}f \leq 0.90 \qquad (90)$$

$$0.67 \leq \{(1-n_3)/r_4\}f \qquad (91)$$

The formula (91) conditions so that the irradiance distribution on the object be uniform or increased in the peripheral area thereof, and that a wide illumination area be ensured. Both the sum of the refracting powers of the rear surface of the first lens $L_1$ and of the front surface of the second lens $L_2$, and the refracting power of the rear surface of the rear surface of the second lens will affect the conjugate relationship between the entrance pupil and the object.

When the value of $\{(1-n_1)/r_2 + (n_3-1)/r_3\}f$ is smaller than -0.68, an intermediate image at the entrance pupil will become excessively small, hence the effective illumination area will become small.

On the contrary, when the value of $\{(1-n_1)/r_2 + (n_3-1)/r_3\}f$ is larger than 0.90, the refracting power of the rear surface of the second lens will become small in order to keep the conjugate relationship. The rear surface $r_4$ of the second then lens will not effectively affect the irradiance distribution, and accordingly, when the value of $\{(1-n_1)/r_2 + (n_3-1)/r_3\}f$ is larger than 0.90 and the value of $\{(1-n_3)/r_4\}f$ is smaller than 0.67, the irradiance reduction in the intermediate area becomes excessively large, and further the irradiance in the peripheral area becomes decreased.

Hereinafter described are examples of the optical system of this embodiment. In the following examples, the optical system L (i.e. optical system 3 in Figure 9) is designed so that the diameter of the light source: 17.64 (maximum incident angle: $\omega_{max}$ = 10 degrees); the distance a between the light source and the entrance pupil: 50; the distance between the rear surface of the optical system and the object: 100; the diameter of the object: 90 (maximum exit angle: $\theta_{max}$ = 24.2 degrees); the effective diameter of the lens: 1.0; and the synthesized focal length of the optical system as a whole: 1.0.

FIRST EXAMPLE

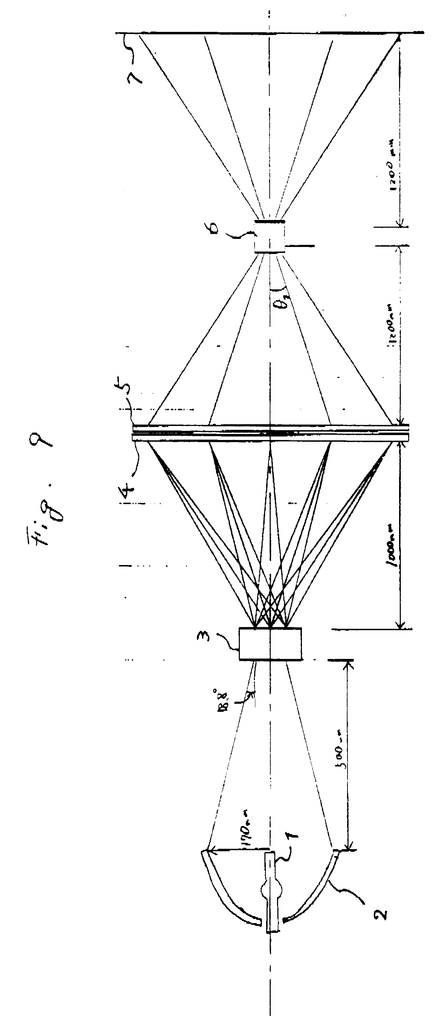

Referring to Figure 10, which shows a side view of the optical system 3 of this example, the optical system comprises two optical units including two lenses $L_1$ und $L_2$, wherein the optical system satisfies the following formulae:

$$\{(1-n_1)/r_2 + (n_3-1)/r_3\}f = -0.011 \qquad (92)$$

$\{(1-n_3)/r_4\}f = 1.429 \quad (93)$

Then lens data of the optical system are shown in Table 31.

TABLE 31

|   | r | d | n |
|---|---|---|---|
| 1 | 1.474 | 1.062 | 1.95 |
| 2 | -0.914 | 0.308 | |
| 3 | -0.683 | 0.464 | 1.717552 |
| 4 | -0.502 | | |

Figure 13 shows an irradiance distribution on the object, from which it is understood that irradiance reduction in the intermediate area is within 3 percent, and that the irradiance in the peripheral area is effectively increased. This example is a standard case among the examples.

SECOND EXAMPLE

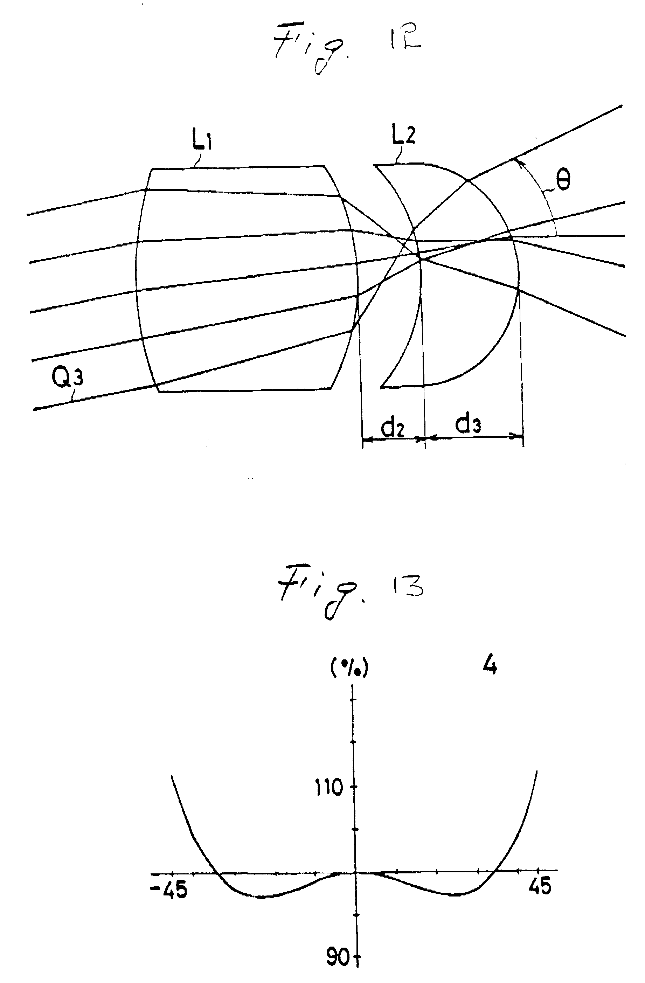

Referring to Figure 14, which shows a side view of the optical system 3 of this example, the optical system comprises two optical units including two lenses $L_1$ and $L_2$, wherein the optical system satisfies the following formulae:

$\{(1-n_1)/r_2 + (n_3-1)/r_3\}f = 0.895 \quad (94)$

$\{(1-n_3)/r_4\}f = 0.676 \quad (95)$

The lens data of this optical system are shown in Table 32.

TABLE 32

|   | r | d | n |
|---|---|---|---|
| 1 | 10.897 | 0.948 | 1.95 |
| 2 | -0.991 | 0.388 | |
| 3 | -7.048 | 0.780 | 1.45 |
| 4 | -0.666 | | |

Figure 15 shows an irradiance distribution on the object, from which it is understood that the irradiance reduction in the intermediate area of the object is within several percent, and that the irradiance in the peripheral area is to the contrary increased several percent.

This example is the case where the value of $\{(1-n_1)/r_2 + (n_3-1)/r_3\}f$ is close to the maximum value of the conditional formula (90) and the value of $\{(1-n_3)/r_4\}f$ is close to the minimum value of the formula (91).

THIRD EXAMPLE

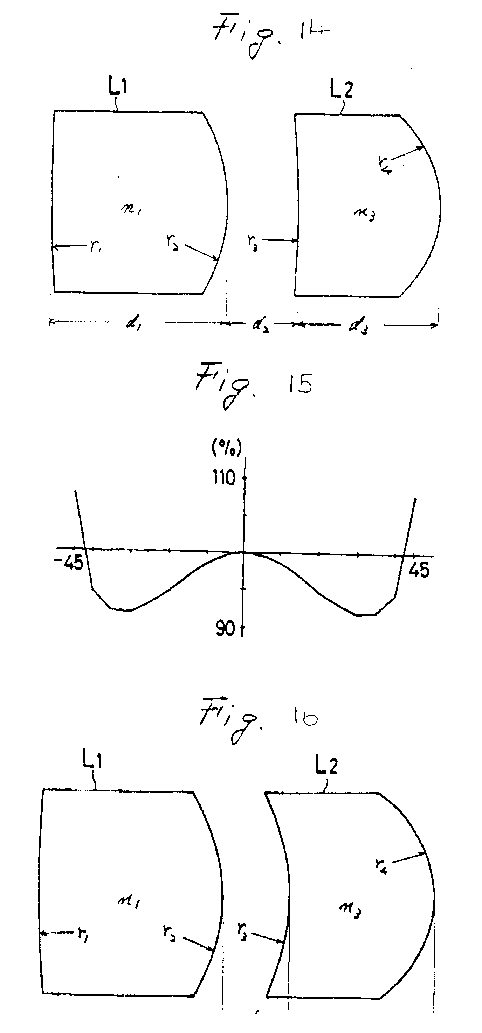

Referring to Figure 16, which shows a side view of the optical system 3 of this example, the optical system comprises two optical units including two lenses $L_1$ and $L_2$, wherein the optical system satisfies the following formulae:

$\{(1-n_1)/r_2 + (n_3-1)/r_3\}f = 0.522 \quad (96)$

$\{(1-n_3)/r_4\}f = 0.911 \quad (97)$

The lens data of this optical system are shown in Table 33.

9

TABLE 33

|   | r | d | n |
|---|---|---|---|
| 1 | 6.289 | 0.887 | 1.95 |
| 2 | -0.945 | 0.328 | |
| 3 | -1.141 | 0.703 | 1.551803 |
| 4 | -0.606 | | |

Figure 17 shows an irradiance distribution on the object, from which it is understood that the irradiance reduction in the intermediate area is within several percent, and that the irradiance in the peripheral area is sufficiently increased.

FOURTH EXAMPLE

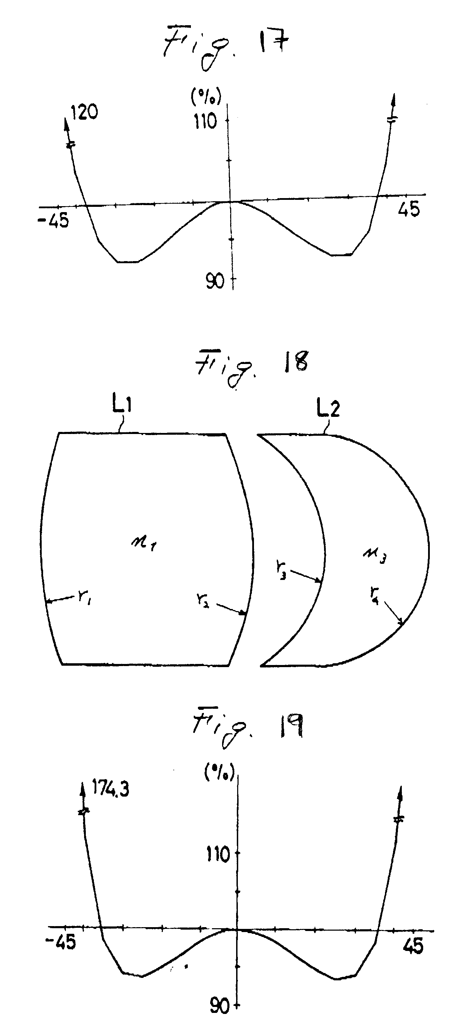

Referring to Figure 18, which shows a side view of the optical system 3 of this example, the optical system comprises two optical units including two lenses $L_1$ and $L_2$, wherein the optical system satisfies the following formulae:

$$\{(1-n_1)/r_2 + (n_3-1)/r_3\}f = -0.680 \qquad (98)$$

$$\{(1-n_3)/r_4\}f = 1.742 \qquad (99)$$

The lens data of this optical system are shown in Table 34.

TABLE 34

|   | r | d | n |
|---|---|---|---|
| 1 | 1.461 | 0.911 | 1.900671 |
| 2 | -1.133 | 0.297 | |
| 3 | -0.593 | 0.447 | 1.874634 |
| 4 | -0.502 | | |

Figure 19 shows an irradiance distribution on the object, from which it is understood that the irradiance reduction in the intermediate area is within several percent, and that the irradiance in the peripheral area is sufficiently increased.

FIFTH EXAMPLE

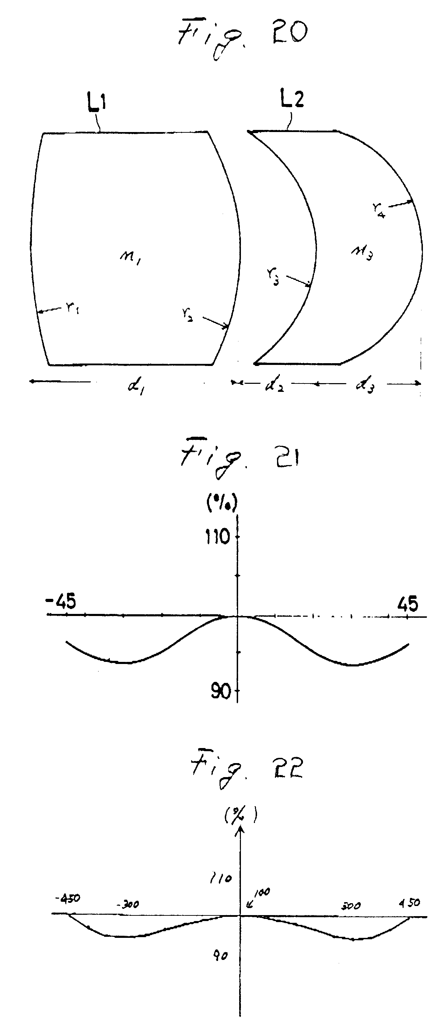

Referring to Figure 20, which shows a side view of the optical system 3 of this example, the optical system comprises two optical units including two lenses $L_1$ and $L_2$, wherein the optical system satisfies the following formulae:

$$\{1-n_1)/r_2 + (n_3-1)/r_3\}f = -0.302 \qquad (100)$$

$$\{(1-n_3)/r_4\}f = 1.416 \qquad (101)$$

The lens data of this optical system are shown in Table 35.

TABLE 35

|   | r | d | n |
|---|---|---|---|
| 1 | 1.870 | 0.905 | 1.95 |
| 2 | -0.991 | 0.320 | |
| 3 | -0.589 | 0.471 | 1.742235 |
| 4 | -0.524 | | |

Figure 21 shows an irradiance distribution on the object, from which it is understood that the irradiance is within ±3 percent throughout the object.

In the aforementioned embodiments, the optical system 3 is formed into a so-called fly's eye configuration, in which a plurality of element lenses are aligned two-dimensionally. Such fly's eye configuration is especially advantageous for use in an illumination apparatus.

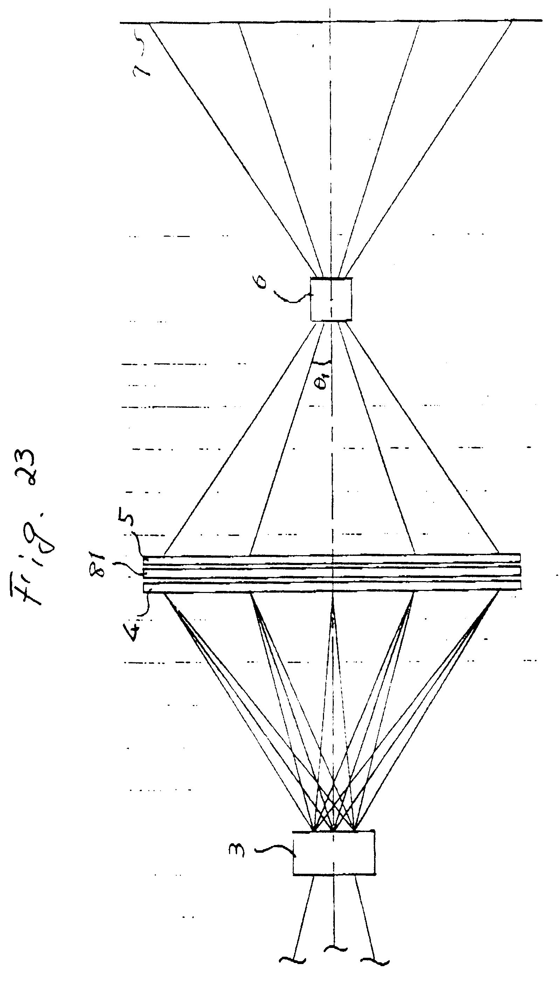

According to the present invention, in the case where a projection lens 6 is disposed behind an object to be illuminated (i.e. an original 5), as shown in Figure 9, the irradiance distribution on a photosensitive material 7 will come into uniform throughout the entire surface thereof despite of the cosine fourth law caused by the projection lens. The examples where the irradiance is gradually increased in the peripheral area of the object may particularly be adaptable for obtaining a uniform irradiance on the photosensitive material. For instance, when the example shown in Figures 10 and 11-(A) through 11-(C) is employed in the optical system 3 shown in Figure 9, the irradiance distribution will come into uniform on the photosensitive material 7, which irradiance distribution is shown in Figure 22.

MODIFIED EMBODIMENT

Referring to Figure 23, which shows another illumination apparatus according to the present invention, the structure of the illumination apparatus is basically the same as that shown in Figure 9 except an application of a Fresnel lens. The Fresnel lens 81 is designed that the focal length thereof is 1200 mm, and is disposed between the diffusing plate 4 and the original to be illuminated 5.

When the Fresnel lens 81 is placed in such a manner as above, the irradiance in the peripheral area of the photosensitive material 7 will reduced according to the cosine third law. The application of the optical system 3 will, however, correct the irradiance distribution on the photosensitive material 7.

The aforementioned embodiments are in the case where no vignetting is caused. Some projection lenses may often cause the vignetting, as the field angle $\theta_1$ thereof increases. In this case, the irradiance on the object to be illuminated can be expressed by the product of both $\cos^4 \theta_1$ and the vignetting factor of the projection lens to be used.

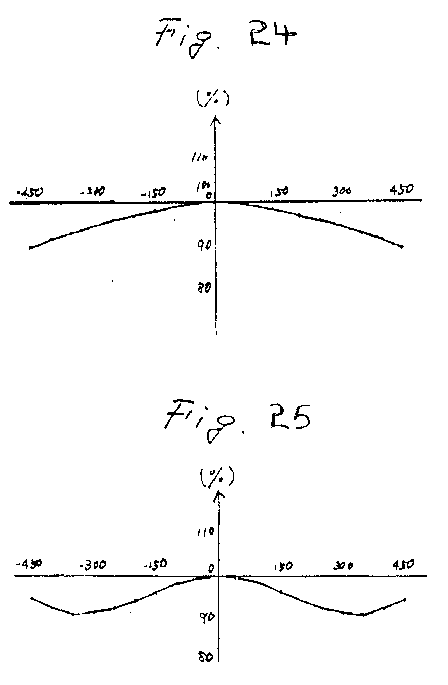

Figure 24 shows an example of the vignetting factor of a projection lens. In the case where the illumination apparatus shown in Figure 23 is used, which case will cause the irradiance reduction according to the cosine third law, the irradiance distribution on the photosensitive material 7 results as shown in Figure 25, from which the irradiance distribution is within ±5 percent.

While the invention has been illustrated and described as embodied an illumination apparatus, it is not intended to be limited to the details shown, since various modifications and structural changes may be made without departing in any way from the present invention.

Without further analysis, the foregoing will so fully reveal the gist of the present invention that others can, by applying current knowledge, readily adapt it for various applications without omitting features that, from the standpoint of prior art, fairly constitutes essential characteristics of the generic or specific aspects of this invention.

What is claimed as new and desired to be protected by letters patent is set forth in the appended claims.

**Claims**

1. An optical system for use in illuminating an object, the optical system (3) comprising a first optical unit (L1) including a positive lens and a second optical unit (L2) including a positive lens, wherein the first optical unit has a rear surface which is formed into convex, and the second optical unit has both a front surface which is formed into concave and a rear surface which is formed into convex,
characterized in that
the optical system satisfies the following formula:

$$-0{,}68 \leq \{\ (\ 1 - n_1\ )\ /\ r_2\ +\ (\ n_3 - 1)\ /\ r_3\ \}f < 0{,}90$$
$$0{,}67 \leq \{\ (\ 1 - n_3\ )\ /\ r_4\ \}f$$

where f is the focal length of the optical system; $r_2$, $r_3$ and $r_4$ are a radius of curvature of the rear surface of the first optical unit, of the front and rear surfaces of the second optical unit, respectively; and $n_1$ and $n_3$ are refractive indexes of the first and second optical units.

2. An optical system as set forth in claim 1, wherein the optical system comprises a plurality of element lenses which are formed into fly's eye configuration.

## Patentansprüche

1. Ein optisches System zur Verwendung bei der Beleuchtung eines Gegenstandes, wobei das optische System (3) eine erste optische Einheit (L1) mit einer positiven Linse und eine zweite optische Einheit (L2) mit einer positiven Linse aufweist und wobei die erste optische Einheit eine rückwärtige Fläche hat, die konvex ausgebildet ist und die zweite optische Einheit sowohl eine vordere Fläche, die konkav ausgebildet ist und eine rückwärtige Fläche, die konvex ausgebildet ist, hat,
dadurch gekennzeichnet, daß
das optische System die folgenden Ungleichungen erfüllt:

$$-0{,}68 \leq \{(1 - n_1)/r_2\ +\ (n_3 - 1)/r_3\}f < 0{,}90$$
$$0{,}67 \leq \{(1 - n_3)/r_4\}f$$

wobei f die Fokuslänge des optischen Systems ist; $r_2$, $r_3$ und $r_4$ die Radien der rückwärtigen Flächen der ersten optischen Einheit, der Vorderfläche bzw. der rückwärtigen Fläche der zweiten optischen Einheit sind; und $n_1$ und $n_3$ die Refraktionsindexes der ersten und der zweiten optischen Einheiten sind.

2. Ein optisches System nach Anspruch 1, wobei das optische System eine Vielzahl von Elementenlinsen aufweist, die fliegenaugenartig ausgebildet sind.

## Revendications

1. Système optique pour illuminer un objet, système optique (3) comprenant une première unité optique (L1) comprenant une lentille positive et une seconde unité optique (L2) comprenant une lentille positive, système dans lequel la première unité optique possède une surface arrière convexe et la seconde unité optique possède, à la fois, une surface avant concave et une surface arrière convexe,
système caractérisé en ce qu'il obéit à la relation suivante :

$$-0{,}68 \leq \{\ (1 - n_1)\ /\ r_2\ +\ (n_3 - 1)\ /\ r_3\ \}f < 0{,}90$$
$$0{,}67 \leq \{\ (1 - n_3)\ /\ r_4\ \}f$$

où f est la longueur focale du système optique; $r_2$, $r_3$ et $r_4$ sont des rayons respectifs de courbure de la surface arrière de la première unité optique, des surfaces avant et arrière de la seconde unité optique; et $n_1$ et $n_3$ sont des indices de réfraction des première et seconde unités optiques.

2. Système optique selon la revendication 1, comprenant une pluralité d'éléments de lentille présentant une configuration en oeil de mouche.

# FIG. 7

Prior Art

# FIG. 2

Prior Art

FIG. 3

Prior Art

FIG. 4

Prior Art

FIG. 5

Prior Art

FIG. 6

Prior Art

FIG. 7

Prior Art

Fig. 8

Fig. 9

Fig. 10

Fig. 11

Fig. 12

Fig. 13

19

Fig. 14

Fig. 15

Fig. 16

## Fig. 17

## Fig. 18

L1    L2

$n_1$    $M_3$

$r_1$    $r_2$    $r_3$    $r_4$

## Fig. 19

Fig. 20

Fig. 21

Fig. 22

Fig. 23

Fig. 24

Fig. 25